# EUROPEAN PATENT APPLICATION

(11) **EP 2 981 160 A1**
(43) Date of publication of application: **03.02.2016**
(21) Application number: 15179343.7
(22) Date of filing: 31.07.2015
(51) Int. Cl.: H05K 7/20, F28D 15/02

(54) **SET-TOP BOX**

(30) Priority: 01.08.2014 KR 20140098978
(71) Applicant: Samsung Electronics Co., Ltd., Suwon-si, Gyeonggi-do (KR)
(72) Inventor: Kim, Jung Kyun, Gyeonggi-do (KR); Cho, Jin Hyun, Seoul (KR)
(74) Representative: Walaski, Jan Filip

(57) **Abstract**

A set-top box with a heat dissipation device is provided to improve heat dissipation efficiency. The set-top box includes a main body configured to form an exterior, a circuit board provided inside the main body, and a heat dissipation device provided to cool heat generated from the circuit board. The heat dissipation device includes a heat pipe provided to be in contact with at least one surface of the circuit board.

## Description

The invention relates to a set-top box with a heat dissipation device provided to improve heat dissipation efficiency.

In general, a set-top box (STB) is a signal conversion device that receives broadcast signals transmitted from a ground wave cable or a satellite, so that the signals can be displayed through a display device, such as a television (TV). The STB receives the broadcast signals using a tuner, converts the received signals into video, audio, text, etc. using a decoder, and sends the converted results to the TV. When a program which a user wants to view is selected, data of the selected program is transmitted to the STB through, for instance, the cable, and the user can view the desired program through the display device connected to the STB.

With the advent of digital broadcasting services, the number of channels for broadcasts transmitted from ground wave cables or the satellites has increased explosively. To receive broadcasts of numerous channels, an STB for processing the data to receive the broadcast signals from broadcasters and then output the received broadcast signals to the display device including the TV is required.

An STB can demodulate digital broadcast signals for video, audio, text, etc. and output the demodulated digital broadcast signals through output terminals, such as an audio/video (A/V) terminal, a composite terminal, a component terminal, a high definition multimedia interface (HDMI) terminal, an RF modulator terminal, and so on.

In the case of an STB connected to a TV, the STB organically operates with the TV and is controlled by a separate STB remote controller. When the broadcasts are viewed via the STB, the TV is merely an appliance for displaying output, and interactions of the user with the broadcasts, such as actual channel surfing, volume adjustment, etc.. of the TV, are performed through the STB remote controller.

Since primary functions relevant to the broadcasts are performed at the STB, much heat is emitted from a circuit board or a hard drive of the STB. As the number of channels used in the STB increases, the temperature increases because of the increase on the volume of data to be processed by the hard drive. This heat may be responsible for malfunction or breakdown of the STB. Therefore, various heat dissipation devices may be provided for the STB.

Additional aspects and/or advantages will be set forth in part in the description which follows and, in part, will be apparent from the description, or may be learned by practice of the embodiments.

Additional aspects of the embodiments will be set forth in part in the description which follows and, in part, will be obvious from the description, or may be learned by practice of the embodiments.

Therefore, it is an aspect of the embodiments to provide a set-top box with a heat dissipation device provided to improve heat dissipation efficiency.

In accordance with an aspect of the embodiments, a set-top box includes: a main body configured to form an exterior; a circuit board provided inside the main body; and a heat dissipation device provided to cool heat generated from the circuit board. The heat dissipation device includes a heat pipe provided to be in contact with at least one surface of the circuit board.

Here, the heat pipe may include a flat shape.

Further, the heat pipe may be formed of an aluminium material.

Also, the heat pipe may include a plurality of channels and a heat conducting medium injected into the plurality of channels under vacuum.

Here, the heat conducting medium may include a fluorinated inert fluid.

Further, the heat pipe may have at least one thermal adhesive of thermal grease and a phase change material (PCM) applied to at least one surface thereof.

Also, the heat pipe may have one end that is in contact with the circuit board, and the other end formed as a free end.

Further, the heat pipe may be configured in such a manner that at least a part of one end thereof is in contact with the circuit board and that at least a part of the other end thereof is formed with a height difference so as to be spaced apart from the circuit board.

Further, at least one connector may be disposed in the rear of the main body, and the heat pipe may be disposed to transfer heat toward sides of the main body.

Also, the heat pipe may further include a fixing member provided to be fixed to the circuit board.

In accordance with another aspect of the embodiments, a set-top box includes: a main body configured to form an exterior; a circuit board provided inside the main body; and a heat dissipation device provided to cool heat generated from the circuit board. The heat dissipation device includes a heat pipe having a plate shape, and the heat pipe is formed of aluminium.

Here, the heat dissipation device may be subjected to extrusion as a flat aluminium heat pipe, ultrasonic cleaning, de-aerating and drying, removal of oil, lower end sealing, primary vacuum processing, injection of a heat medium, secondary vacuum processing, and upper end sealing.

Further, the heat medium may include a fluorinated inert fluid.

In addition, the heat pipe may be configured in such a manner that at least a part of one end thereof is in contact with the circuit board and that at least a part of the other end thereof is formed with a height difference so as to be spaced apart from the circuit board.

According to the set-top box of the embodiments, heat dissipation efficiency can be improved by the plate-like heat pipe.

In accordance with another aspect of the embodiments a set-top box includes a main body configured to form an exterior, a circuit board provided inside the main body and a heat pipe provided to cool heat generated from the circuit board, where the heat pipe is in contact with at least one surface of the circuit board.

Further, it is possible to save a cost and secure long-term reliability of the set-top box.

These and/or other aspects of the embodiments will become apparent and more readily appreciated from the following description of the embodiments, taken in conjunction with the accompanying drawings in which:
FIG. 1 is a view illustrating a typical broadcast receiving system;
FIG. 2 is an explosive perspective view illustrating a set-top box according to an embodiment;
FIG. 3 is a schematic perspective view illustrating a heat dissipation device for the set-top box according to the embodiment;
FIG. 4 is an explosive perspective view illustrating a heat dissipation device for the set-top box according to the embodiment;
FIG. 5 is a sectional enlarged view taken along line A-A' of FIG. 4;
FIG. 6 is a side view in which a heat pipe of the heat dissipation device according to the embodiment is installed on a circuit board of the set-top box;
FIG. 7 is a flow chart illustrating a method of manufacturing the heat pipe of the heat dissipation device according to the embodiment; and
FIG. 8 is a schematic view illustrating a heat dissipation device for a set-top box according to another embodiment.

Hereinafter, embodiments will be described in detail with reference to the accompanying drawings.

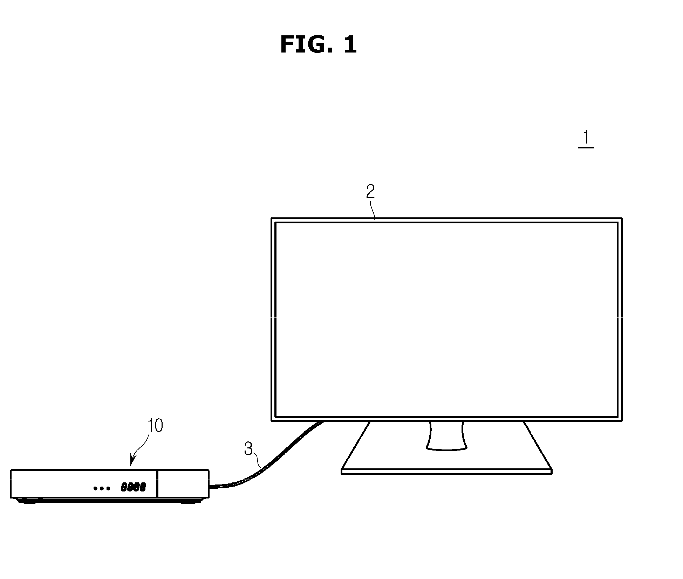

FIG. 1 is a view illustrating a typical broadcast receiving system.

Referring to FIG. 1, a broadcast receiving system 1 includes a display device 2 and a set-top box 10. The display device 2 and the set-top box 10 are connected by a cable 3, and an electrical signal of the set-top box (STB) 10 may be transmitted to the display device 2.

Although not illustrated, the set-top box 10 may include some or all of a signal receiver, a signal processor, a memory, a controller, and a signal output.

The signal receiver may receive broadcast signals of ground wave broadcasting, cable broadcasting, and satellite broadcasting. Here, the broadcast signals may be received based on at least one of an analog mode and a digital mode.

The broadcast signal received for a specific channel by the signal receiver may be transmitted to the signal processor. The signal processor receives the broadcast signal for the specific channel and splits the received broadcast signal into video and audio data. The signal processor modulates the video and audio data according to a specific standard, and provides the modulated video and audio data to the signal output. The video and audio data split at the signal processor may be stored in the memory under the control of the controller.

The signal output outputs the video and audio data provided at the signal processor. The signal output may be in the form of a connector or jack. The signal output may be connected to the display device 2 by the cable 3. The display device 2 may display the broadcast signal received from the signal output on a screen.

Further, a user may perform channel surfing or volume adjustment on the channels output to the display device 2 using a set-top box.

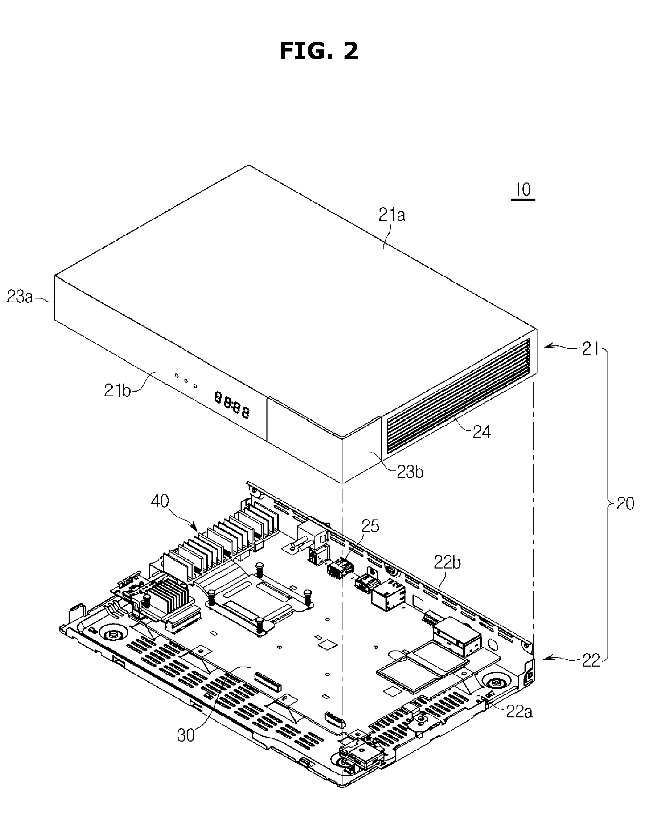

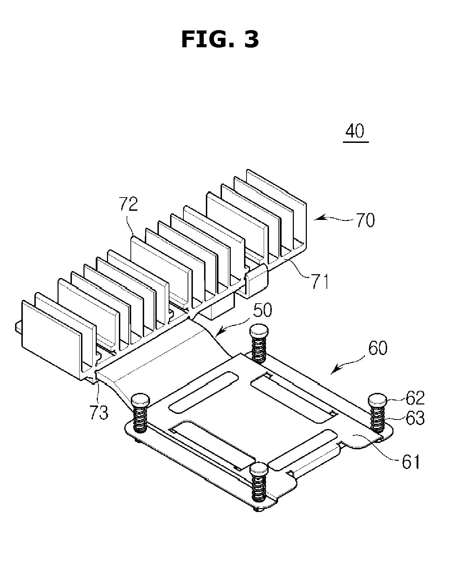

As illustrated in FIGS. 2 and 3, the set-top box 10 includes a main body 20 forming an exterior, and a circuit board 30 provided inside the main body 20. The circuit board 30 may be housed inside the main body 20.

The main body 20 may include a bottom plate 22 and a top cover 21 coupled to an upper portion of the bottom plate 22. The circuit board 30 is disposed on top of the bottom plate 22, and may take part in overall control of the set-top box 10.

Meanwhile, the main body 20 may be provided with a hard drive (not shown) acting as a memory in which a program for driving the set-top box 10 and data generated during the driving of the set-top box 10 can be temporarily stored.

The bottom plate 22 includes a bottom 22a. The circuit board 30 may be placed on the bottom 22a.

The top cover 21 may include a top plate 21a, first and second sides 23a and 23b that extend downward from both ends of the top plate 21a, and a front plate 21b that connects the first and second sides 23a and 23b. The first side 23a, the second side 23b, and the front plate 21b may be provided to correspond to an outer boundary of the bottom plate 22.

Further, a rear plate 22b of the set-top box 10 may be formed upward in the rear of the bottom plate 22. The rear plate 22b of the bottom plate 22 may be provided with various external signal input connectors 25 to be connected to the circuit board 30.

In the embodiment, an example in which the rear plate 22b is integrally formed in the rear of the bottom plate 22 is illustrated, but the spirit of the embodiments is not limited thereto. For example, the rear plate may be formed at the top cover 21.

The first and second sides 23a and 23b of the top cover 21 may be provided with a plurality of discharge holes 24, such that air raised to a high temperature by heat generated inside the set-top box 10 can be discharged from the set-top box 10. In the embodiment, an example in which the discharge holes 24 are elongately formed in the first and second sides 23a and 23b of the top cover 21 in a longitudinal direction is illustrated, but the spirit is not limited thereto. For example, the discharge holes 24 may be formed in at least one of the bottom 22a of the bottom plate 22 and the top plate 21a of the top cover 21.

The heat generated from the circuit board 30 of the set-top box 10 can be discharged from the main body 20 by a flow of the air that flows in and out through the discharge holes 24 of the first and second sides 23a and 23b of the set-top box 10.

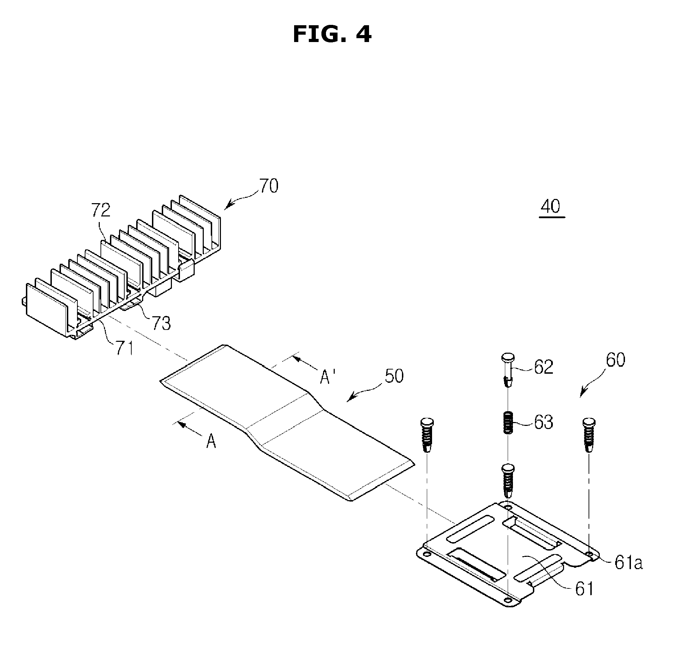

Meanwhile, the set-top box 10 includes a heat dissipation device 40 provided to discharge the heat from the circuit board 30. As illustrated in FIGS. 4 to 6, the heat dissipation device 40 may be provided for the circuit board 30 such that the heat generated from the circuit board 30 is efficiently dissipated.

The heat dissipation device 40 may be provided to be in direct contact with the circuit board 30 or to be in indirect contact with the circuit board 30 via various components disposed on the circuit board 30.

The various components disposed on the circuit board 30 may include an integrated circuit chip for processing signals, an HDD installed on the circuit board 30, a power supply from which heat is easily generated, and circuit elements such as a resistor.

The heat dissipation device 40 may include a heat pipe 50. The heat pipe 50 is formed in a flat shape.

The heat pipe 50 may be formed of a metal material, such as aluminium, having a high heat transfer coefficient.

The heat dissipation device 40 may include a fixing member 60 that is provided to fix the flat heat pipe 50 to the circuit board 30, and a heat sink 70 that is fixed at one side of the heat pipe 50 for the purpose of efficient heat dissipation.

The heat sink 70 may be provided in a fin type or a type having a plurality of pins. In the present embodiment, an example in which the heat sink 70 includes a plurality of fins 72 protruding upward from a plate 71 to which the heat pipe 50 is fixed is illustrated, but the spirit is not limited thereto.

A lower surface of the plate 71 of the heat sink 70 may be provided with couplers 73 to which the heat pipe 50 is fixed. In the present embodiment, an example in which each of the couplers 73 is a bracket protruding downward, such that the heat pipe 50 is slidably inserted therein, is illustrated, but the spirit is not limited thereto.

Further, the fixing member 60 is preferably formed to surround the outside of the heat pipe 50 such that at least one surface of one end of the heat pipe 50 can be at least in contact with the fixing member 60.

The fixing member 60 may include a fixing bracket 61 surrounding the heat pipe 50, and fixing pins 62 provided to fix the fixing bracket 61 to the circuit board 30.

Corners of the fixing bracket 61 may be provided with fixing holes 61a into which the fixing pins 62 are inserted. The fixing pins 62 are inserted into the respective fixing holes 61a to fix the fixing bracket 61 to the circuit board 30.

At this time, an elastic member 63, such as a spring, may be provided between the fixing bracket 61 and each of the fixing pins 62.

In the present embodiment, an example in which heat pipe 50 is fixed by the fixing bracket 61 and the fixing pins 62 is illustrated, but the spirit is not limited thereto. For example, various devices and methods for fixing the heat pipe to the circuit board may be used.

Meanwhile, one end of the heat pipe 50 may be brought into contact with the circuit board 30 by the fixing member 60, and the other end of the heat pipe 50 may be formed as a free end.

Further, at least one thermal adhesive 58 of thermal grease and a phase change material (PCM) is preferably applied to at least one surface of the heat pipe 50 for the contact with the circuit board 30.

The thermal adhesive 58 is provided to be able to relieve a shock between the components, and particularly between the circuit board 30 and the heat pipe 50.

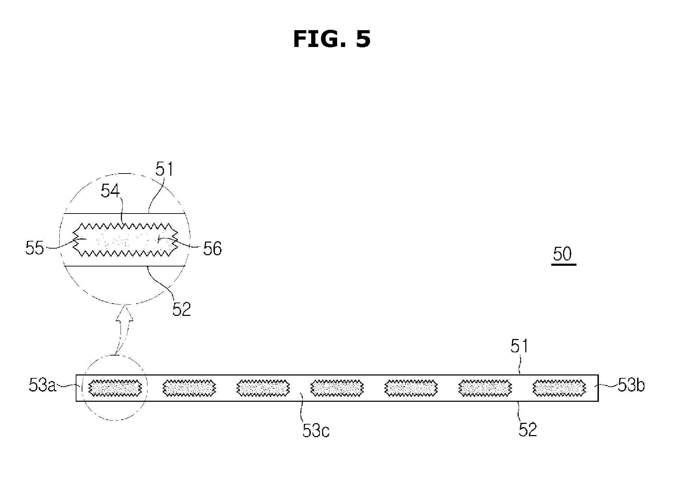

The heat pipe 50 may include a plate-like upper surface 51, a lower surface 52 that is opposite to and away from the upper surface 51, a plurality of lateral surfaces 53a, 53b and 53c (see FIG. 5) that connect the upper surface 51 and the lower surface 52, a plurality of channels 56 that are formed between the upper surface 51 and the lower surface 52, and a heat medium 55 that is injected into the plurality of channels 56 under vacuum.

The plurality of lateral surfaces 53a, 53b and 53c may include a first lateral surface 53a that connects one end of the upper surface 51 and one end of the lower surface 52, a second lateral surface 53b that connects the other ends of the upper and lower surfaces 51 and 52, and a plurality of third lateral surfaces 53c that uniformly partitions or provides a space between the first lateral surface 53a and the second lateral surface 53b to form the plurality of channels 56.

The plurality of channels 56 provided in a transverse direction may have empty interiors into which a fluorinated inert fluid can be injected under vacuum.

Meanwhile, each of the channels 56 is provided with a plurality of capillary grooves 54 in an inner surface thereof to allow the heat medium 55 to smoothly flow in each of the channels 56. The capillary grooves 54 allow the heat medium 55 to smoothly flow due to a capillary phenomenon.

An operation of the heat pipe 50 will be described below. The heat medium 55 injected into the channels 56 under vacuum flows along the capillary grooves 54 in the plurality of channels 56, and emits heat due to a change in phase.

To be specific, if heat is transferred from one end of the heat pipe 50 that is in contact with the circuit board 30, i.e. a heat source, the heat medium 55 undergoes a phase change from a liquid to a gas, and the evaporated heat medium 55 is raised in pressure and moves toward the heat sink 70. The heat medium 55 whose heat is discharged to the outside by the heat sink 70 is condensed into a liquid phase, and the heat medium 55 of the liquid phase repetitively emits heat toward the heat source by the capillary phenomenon.

The heat transferred in this way can be discharged from the main body 20 through the discharge holes 24 of the top cover 21.

At least a part of the heat pipe 50 is formed with a height difference in such a manner that at least a part of the one end of the heat pipe 50 can be in contact with the circuit board 30 and that at least a part of the other end of the heat pipe 50 can be spaced apart from the circuit board 30.

Therefore, the heat pipe 50 can be disposed with no interference with the components mounted on the circuit board 30 at various heights, and the heat can be efficiently dissipated.

At this time, the heat pipe 50 may be formed with a height difference by a bending process.

The heat pipe 50 may include a first surface 51 that is in contact with the circuit board 30, a second surface 52 that is formed opposite to the first surface 51, and a step portion 53 that is provided to connect the first surface 51 and the second surface 52 at different heights.

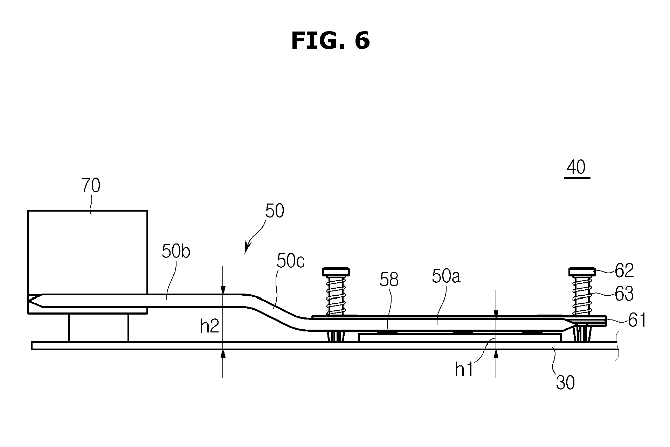

Here, a height h2 (see FIG. 6) of the second surface 52 of the heat pipe 50 from the circuit board 30 is configured to be higher than a height h1 of the first surface 51 of the heat pipe 50 from the circuit board 30.

In the embodiment, an example in which the height h2 of the second surface 52 of the heat pipe 50 is formed to be higher than the height h1 of the first surface 51 of the heat pipe 50 is illustrated, but the spirit is not limited thereto. For example, the heat pipe may be formed to have various areas and heights.

In this way, the step portion 53 of the heat pipe 50 makes it possible to secure a space for providing a smooth air flow between the second surface 52 of the heat pipe 50 and the bottom of the set-top box 10, and between a part of the circuit board 30 and the circuit components such that the heat dissipation efficiency can be improved.

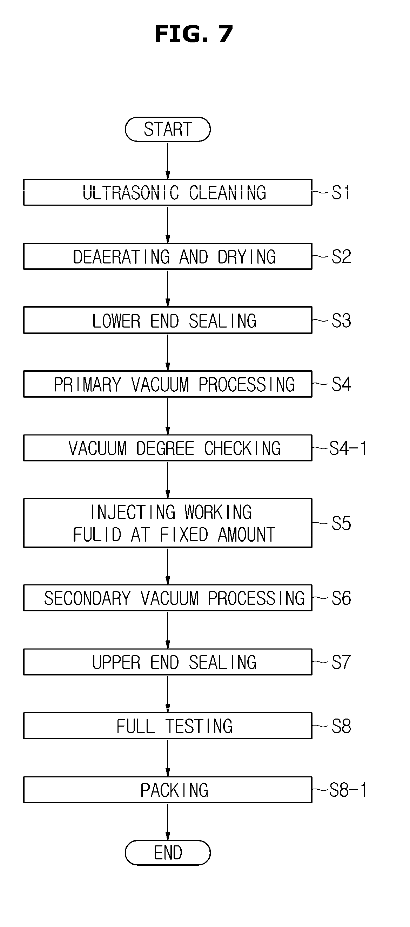

FIG. 7 is a view illustrating a method of manufacturing the heat pipe of the heat dissipation device according to one embodiment.

As illustrated in FIG. 7, a method of manufacturing the heat pipe 50 will be described below.

The heat pipe 50 is extruded from an aluminium material, and undergoes an ultrasonic cleaning step (S1).

At this time, due to an automated cleaning step, it is possible to prevent moisture and ensure uniformity of product.

When the ultrasonic cleaning step (S1) is completed, a de-aerating and drying step (S2) is performed, and thereby oil is removed. When the de-aerating and drying step (S2) is completed, a lower end sealing step (S3) is performed, and a primary vacuum processing step (S4) is performed.

When the primary vacuum processing step (S4) is completed, a vacuum degree checking step (S4-1) is performed, and then a heat medium injecting step (S5) is performed.

When the heat medium injecting step (S5) is completed, a secondary vacuum processing step (S6) is performed. Here, during the heat medium injecting step, injected air and an uncondensed gas may be discharged and the step (S6) removes these gases.

When the secondary vacuum processing step (S6) is completed, an upper end sealing step (S7) is performed.

A full testing step (S8) and a packing step (S8-1) are performed.

Further, since a fluorinated compound is innocuous, odorless, colorless, and nonconductive, it can be very stably used as the heat medium 55, and improve reliability.

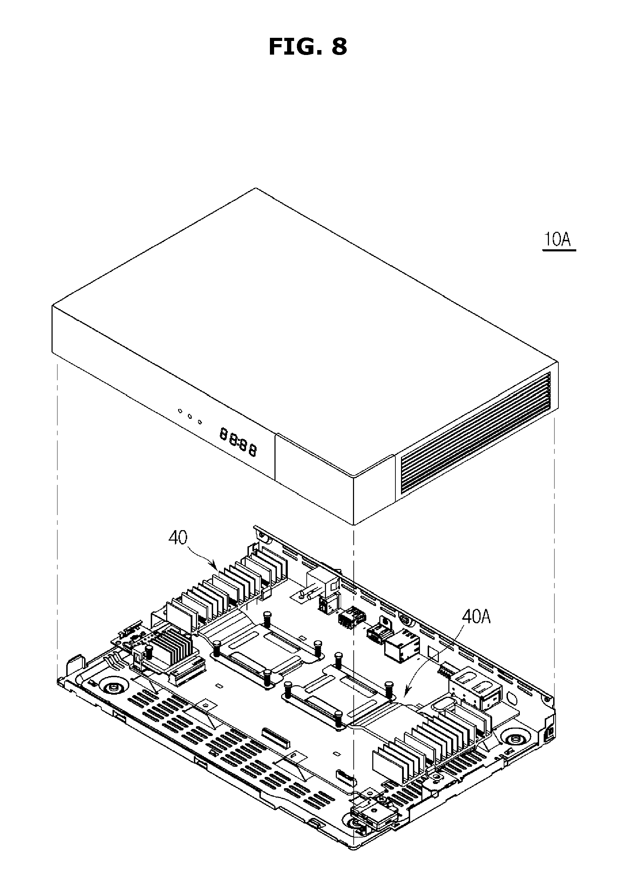

Meanwhile, in the present embodiment, an example in which the single heat dissipation device 40 of the set-top box 10 is installed at one side of the circuit board 30 is illustrated, but the spirit is not limited thereto. For example, as illustrated in FIG. 8, a set-top box 10A according to another embodiment may be configured in such a manner that a plurality of heat dissipation devices 40 and 40A are disposed at both sides of a circuit board 30.

Detailed operation and effects of the plurality of heat dissipation devices 40 and 40A installed in the set-top box 10A can be sufficiently predicted from the contents described above, and duplicate description thereof will be omitted.

Although a few embodiments have been shown and described, it would be appreciated by those skilled in the art that changes may be made in these embodiments without departing from the principles of the invention, the scope of which is defined in the claims.

## Claims

1. A set-top box comprising:
a main body configured to form an exterior;
a circuit board provided inside the main body; and
a heat dissipation device provided to cool heat generated from the circuit board,
wherein the heat dissipation device includes a heat pipe provided to be in contact with at least one surface of the circuit board.

2. The set-top box according to claim 1, wherein the heat pipe includes a flat shape.

3. The set-top box according to claim 1 or 2, wherein the heat pipe is formed of an aluminium material.

4. The set-top box according to claim 1, 2 or 3, wherein the heat pipe includes a plurality of channels and a heat medium injected into the plurality of channels under vacuum.

5. The set-top box according to claim 4, wherein the heat medium includes a fluorinated inert fluid.

6. The set-top box according to any one of the preceding claims, wherein the heat pipe has at least one thermal adhesive of thermal grease and a phase change material (PCM) applied to at least one surface thereof.

7. The set-top box according to any one of the preceding claims, wherein the heat pipe has one end that is in contact with the circuit board, and the other end formed as a free end.

8. The set-top box according to any one of the preceding claims, wherein the heat pipe is configured in such a manner that at least a part of one end thereof is in contact with the circuit board and that at least a part of the other end thereof is formed with a height difference so as to be spaced apart from the circuit board.

9. The set-top box according to any one of the preceding claims, wherein:
at least one connector is disposed in the rear of the main body; and
the heat pipe is disposed to transfer heat toward sides of the main body.

10. The set-top box according to any one of the preceding claims, wherein the heat pipe further includes a fixing member provided to be fixed to the circuit board.

11. A set-top box comprising:
a main body configured to form an exterior;
a circuit board provided inside the main body; and
a heat dissipation device provided to cool heat generated from the circuit board,
wherein the heat dissipation device includes a heat pipe having a plate shape, and
the heat pipe is formed of aluminium.

12. The set-top box according to claim 11, wherein the heat dissipation device is subjected to extrusion to a flat aluminium heat pipe, ultrasonic cleaning, deaerating and drying, removal of oil, lower end sealing, primary vacuum processing, injection of a heat medium, secondary vacuum processing, and upper end sealing.

13. The set-top box according to claim 12, wherein the heat medium includes a fluorinated inert fluid.

14. The set-top box according to claim 11, 12 or 13, wherein the heat pipe is configured in such a manner that at least a part of one end thereof is in contact with the circuit board and that at least a part of the other end thereof is formed with a height difference so as to be spaced apart from the circuit board.
